# EUROPEAN PATENT APPLICATION

(11) **EP 4 746 217 A1**
(43) Date of publication of application: **20.05.2026**
(21) Application number: 25754544.2
(22) Date of filing: 17.03.2025
(51) Int. Cl.: H02B 1/56

(54) **POWER DISTRIBUTION SYSTEM, BATTERY PACK AND ELECTRICAL APPARATUS**

(30) Priority: 30.09.2024 CN 202422415471 U
(71) Applicant: Eve Energy Co., Ltd., Huizhou, Guangdong 516006 (CN)
(72) Inventor: ZHOU, Hongquan, Guangdong 516006 (CN); FAN, Nianzhong, Guangdong 516006 (CN); ZHONG, Yu, Guangdong 516006 (CN)
(74) Representative: HGF
(86) International application number: PCT/CN2025/082946
(87) International publication number: WO 2025/171820

(57) **Abstract**

Provided are a power distribution system, a battery pack, and an electrical device. The power distribution system includes at least one power distribution unit (10). The power distribution unit (10) includes a housing assembly (1), at least one internal component (2), and a heat-conducting member (3). The internal component (2) is disposed within the housing assembly (1). The heat-conducting member (3) is at least partially exposed outside the housing assembly (1). A portion of the heat-conducting member (3) facing inside the housing assembly (1) is in contact with at least one internal component (2). Through the preceding arrangement, heat generated by the internal component during operation is conducted to the outside of the housing assembly through the heat-conducting member, achieving heat dissipation and cooling of the internal component and preventing excessive temperature rise of the internal component and the interior of the entire housing assembly. Disposing at least a portion of the heat-conducting member outside the housing assembly can avoid occupying excessive internal space of the housing assembly and achieve the effect of reducing the overall size of the battery pack and increasing the battery capacity. Moreover, the heat-conducting member located outside the housing assembly has a larger heat dissipation space, thereby facilitating heat dissipation or conduction from the heat-conducting member, improving the heat dissipation performance of the power distribution unit, and ensuring safe and reliable operation of the power distribution unit.

## Description

### CROSS-REFERENCE TO RELATED APPLICATIONS

This application claims priority to Chinese Patent Application No. 202422415471.0 filed with the China National Intellectual Property Administration (CNIPA) on Sep. 30, 2024, the disclosure of which is incorporated herein by reference in its entirety.

### TECHNICAL FIELD

This application relates to the field of battery technology, for example, to a power distribution system, a battery pack, and an electrical device.

### BACKGROUND

A power distribution system of a battery pack includes a power distribution unit, such as a battery disconnect unit (BDU). The battery disconnect unit, also referred to as a high-voltage box, is disposed together with the battery module within a battery casing and is used to connect or disconnect the battery pack from high-voltage electricity, which is critical to the safety of the battery pack.

During operation of the power distribution unit, its internal components generate heat. Excessive temperature rise reduces the current-carrying capacity, thereby affecting the performance of the power distribution unit and, consequently, compromising the safety and stability of the entire battery pack.

For heat dissipation of the power distribution unit, in related art, multiple liquid cooling plates are disposed within the housing of the power distribution unit, achieving heat dissipation through contact with multiple internal components of the power distribution unit.

The related art has the following drawbacks: On the one hand, multiple liquid cooling plates disposed within the housing of the power distribution unit occupy internal space of the power distribution unit, leading to an increase in the volume of the power distribution unit and, consequently, occupying more internal space of the battery pack; on the other hand, both the internal components and the liquid cooling plates of the power distribution unit are located inside the housing, where the limited internal space is not conducive to heat dissipation of the power distribution unit.

### SUMMARY

In a first aspect, this application provides a power distribution system including at least one power distribution unit. The power distribution unit includes a housing assembly, at least one internal component, and a heat-conducting member. The internal component is disposed within the housing assembly. The heat-conducting member is at least partially exposed outside the housing assembly. A portion of the heat-conducting member facing inside the housing assembly is in contact with at least one internal component.

In a second aspect, this application provides a battery pack including a battery module and the power distribution system. The battery module is electrically connected to the power distribution system.

In a third aspect, this application provides an electrical device including an electrical component and the battery pack. The battery pack is configured to provide electrical energy to the electrical component.

This application provides a power distribution system and a battery pack including the power distribution system. At least one internal component is disposed within the power distribution unit of the power distribution system, and the internal component generates heat during operation of the power distribution unit. By the provision of a heat-conducting member in contact with the internal component and at least a portion of the heat-conducting member exposed outside the housing assembly of the power distribution unit, heat generated by the internal component during operation is conducted to the outside of the housing assembly through the heat-conducting member, achieving heat dissipation and cooling of the internal component and preventing excessive temperature rise of the internal component and the interior of the entire housing assembly. On the one hand, disposing at least a portion of the heat-conducting member outside the housing assembly can avoid occupying excessive internal space of the housing assembly, facilitate a reduction in the size of the entire housing assembly, reduce the space occupied by the power distribution unit, save materials, and consequently achieve the effect of reducing the overall size of the battery pack and increasing the battery capacity. On the other hand, the heat-conducting member located outside the housing assembly has a larger heat dissipation space, thereby facilitating heat dissipation or conduction from the heat-conducting member, effectively improving the heat dissipation performance of the power distribution unit, and ensuring safe and reliable operation of the power distribution unit.

The electrical device provided by this application can ensure continuous and reliable power supply to the electrical component while reducing heat generation during power supply. Due to the high-capacity battery pack, the duration of power supply to the electrical component can be extended, enabling the electrical device to have a long battery life and improved practicality.

### BRIEF DESCRIPTION OF DRAWINGS

FIG. 1 is a view illustrating the structure of a power distribution system according to some implementations of this application.
FIG. 2 is a first exploded schematic diagram of a battery disconnect unit according to some implementations of this application.
FIG. 3 is a schematic diagram of internal components and a heat-conducting member of a battery disconnect unit according to some implementations of this application.
FIG. 4 is a second exploded schematic diagram of a battery disconnect unit according to some implementations of this application.
FIG. 5 is a view illustrating the structure of a second housing of a battery disconnect unit according to some implementations of this application.
FIG. 6 is a sectional view of a second housing of a battery disconnect unit according to some implementations of this application.
FIG. 7 is a schematic diagram illustrating the installation of a busbar in a second housing of a battery disconnect unit according to some implementations of this application.
FIG. 8 is an exploded schematic diagram of a boost unit according to some implementations of this application.
FIG. 9 is a schematic diagram of internal components and heat-conducting members of a boost unit according to some implementations of this application.
FIG. 10 is a sectional view of a boost unit according to some implementations of this application.
FIG. 11 is a schematic diagram illustrating a connection between a battery module and a power distribution system according to some implementations of this application.
FIG. 12 is a diagram illustrating the structure of a battery pack and an electrical component according to some implementations of this application.
FIG. 13 is a diagram of a fast-charging interface and a boost circuit according to some implementations of this application.

### Reference list

- 10: power distribution unit
- 110: battery disconnect unit
- 120: boost unit
- 1: housing assembly
- 2: internal component
- 3: heat-conducting member
- 4: circuit board
- 5: heat dissipation module
- 11: first housing
- 12: second housing
- 121: limiting groove
- 122: embedding channel
- 113: third housing
- 14: fourth housing
- 15: bottom cover
- 151: accommodation hole
- 152: heat dissipation hole
- 16: first snap
- 161: snap cavity
- 17: second snap
- 18: installation groove
- 20: battery management system
- 21: electronic component
- 22: busbar
- 221: heat dissipation portion
- 222: installation portion
- 23: filtering module
- 30: copper bar
- 31: first fitting portion
- 32: second fitting portion
- 40: power distribution system
- 41: battery module
- 42: battery pack
- 43: electrical component
- 44: cooling plate
- 45: fast-charging interface
- 46: boost circuit

### DETAILED DESCRIPTION

In the description of this application, unless otherwise expressly specified and limited, a term "connected to each other", "connected", or "secured" is to be construed in a broad sense, for example, as securely connected, detachably connected, or integrated; mechanically connected or electrically connected; directly connected to each other or indirectly connected to each other via an intermediary; or internally connected between two components or interaction relations between two components. For those of ordinary skill in the art, specific meanings of the preceding terms in this application may be construed according to specific situations.

In this application, unless otherwise expressly specified and limited, when a first feature is described as "above" or "below" a second feature, the first feature and the second feature may be in direct contact or be in contact via another feature between the two features instead of being in direct contact. Moreover, when the first feature is "on", "above", or "over" the second feature, the first feature is right on, above, or over the second feature, or the first feature is obliquely on, above, or over the second feature, or the first feature is simply at a higher level than the second feature. When the first feature is "under", "below", or "underneath" the second feature, the first feature is right under, below, or underneath the second feature, or the first feature is obliquely under, below, or underneath the second feature, or the first feature is simply at a lower level than the second feature.

In the description of the embodiments, it is to be noted that orientations or position relations indicated by terms such as "above", "below", "left", and "right" are based on the drawings. These orientations or position relations are intended only to facilitate the description and simplify an operation and not to indicate or imply that a device or element referred to must have such particular orientations or must be configured or operated in such particular orientations. Thus, these orientations or position relations are not to be construed as limiting this application. In addition, terms "first" and "second" are used only to distinguish between descriptions and have no special meaning.

In the embodiments, the term "and/or" only describes an association relationship between associated objects and indicates that three relationships may exist. For example, A and/or B may indicate the following three cases: A exists alone; A and B exist at the same time; and B exists alone. Additionally, the character "/" in this application generally indicates an "or" relationship between associated objects before and after the character.

In the embodiments of this application, the same reference numerals denote the same components, and for brevity, detailed descriptions of the same components are omitted in different embodiments.

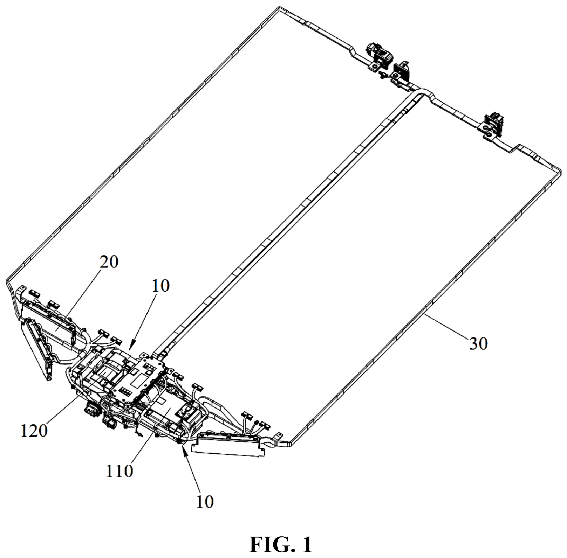

As shown in FIG. 1, this embodiment provides a power distribution system including at least one power distribution unit 10. The power distribution unit 10 includes a housing assembly 1, an internal component 2, and a heat-conducting member 3.

The housing assembly 1 defines a chamber configured to accommodate the internal component 2. At least one internal component 2 is disposed within the chamber of the housing assembly 1. At least one internal component 2 indicates that the housing assembly 1 may contain one internal component 2 or be provided with multiple internal components 2. The heat-conducting member 3 is at least partially exposed outside the housing assembly 1. A portion of the heat-conducting member 3 facing inside the housing assembly 1 is in contact with at least one internal component 2.

The internal component 2 generates heat during operation of the power distribution unit 10. By the provision of a heat-conducting member 3 in contact with the internal component 2 and at least a portion of the heat-conducting member 3 exposed outside the housing assembly 1 of the power distribution unit 10, heat generated by the internal component 2 during operation is conducted to the outside of the housing assembly 1 through the heat-conducting member 3, achieving heat dissipation and cooling of the internal component 2 and preventing excessive temperature rise of the internal component 2 and the interior of the entire housing assembly 1. On the one hand, disposing at least a portion of the heat-conducting member 3 outside the housing assembly 1 can avoid occupying excessive internal space of the housing assembly 1, facilitate a reduction in the size of the entire housing assembly 1, reduce the space occupied by the power distribution unit 10, save materials, and consequently achieve the effect of reducing the overall size of the battery pack and increasing the battery capacity. On the other hand, the heat-conducting member 3 located outside the housing assembly 1 has a larger heat dissipation space, thereby facilitating heat dissipation or conduction from the heat-conducting member 3, effectively improving the heat dissipation performance of the power distribution unit 10, and ensuring safe and reliable operation of the power distribution unit 10.

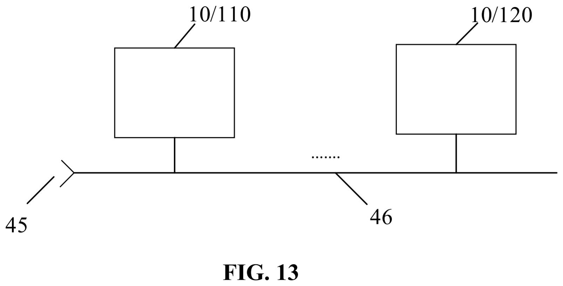

As shown in FIG. 13, in this embodiment, the power distribution system also includes a fast-charging interface 45 and a boost circuit 46, and the fast-charging interface 45 is electrically connected to the boost circuit 46. The fast-charging interface 45 is configured to connect to a standard charging plug at a charging station, such as a charging plug of a 400 V charging pile. Multiple power distribution units 10 are provided, as shown in FIG. 1, where two power distribution units 10 are a battery disconnect unit 110 (BDU, also referred to as a high-voltage box) and a boost unit 120, respectively. Both the battery disconnect unit 110 and the boost unit 120 are disposed on the boost circuit 46. The boost unit 120 is configured to increase voltage. When a user requires 800 V fast charging, the charging plug of a 400 V charging pile is inserted into the fast-charging interface 45, and the boost unit 120 on the boost circuit 46 boosts the voltage to meet the 800 V high-voltage fast-charging requirement. The provision of the boost unit 120 ensures that conventional charging piles can meet the 800 V fast-charging requirement and reduce charging anxiety caused by the limited availability of 800 V high-voltage fast-charging piles at new energy vehicle charging stations and the time spent searching for such charging piles.

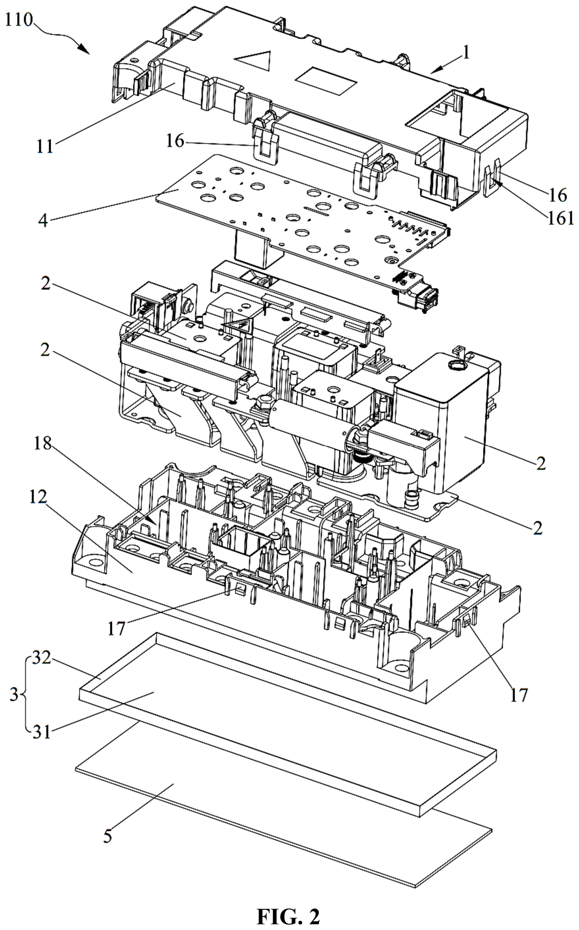

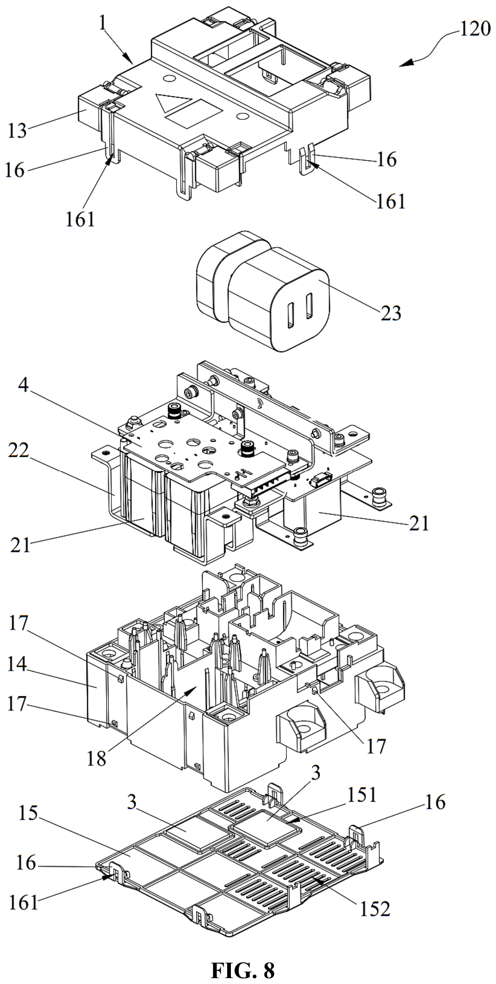

Due to the relatively high current during fast charging, the boost unit 120 and the battery disconnect unit 110 generate more heat. Therefore, disposing the heat-conducting member 3, which is in contact with the internal component 2 on the boost unit 120 and the battery disconnect unit 110, at least partially outside the housing assembly 1 facilitates accelerated heat dissipation and cooling of the internal component 2 and the interior of the entire housing assembly 1. As shown in FIG. 2 to FIG. 7, schematic diagrams of the battery disconnect unit 110 are provided. As shown in FIG. 8 to FIG. 10, schematic diagrams of the boost unit 120 are provided.

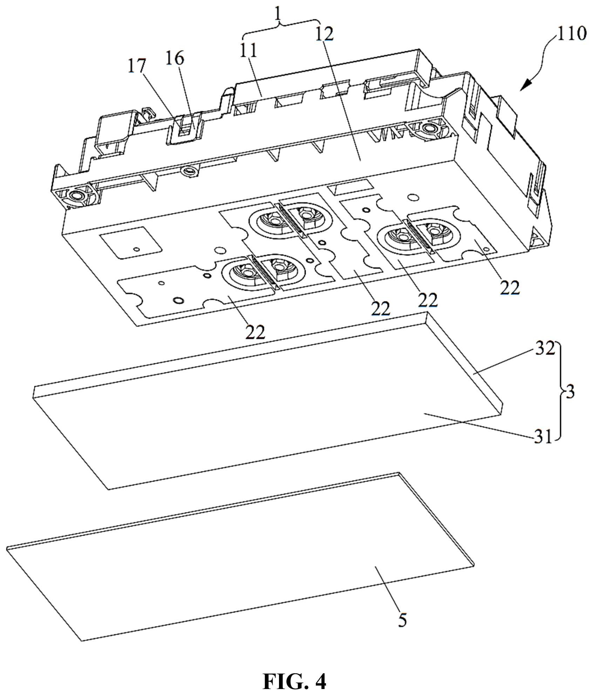

With reference to FIG. 2 and FIG. 4, the housing assembly 1 of the battery disconnect unit 110 includes a first housing 11 and a second housing 12 that are in a snap-fit. The two housings, after snapping, define a chamber configured to accommodate the internal component 2. One of the first housing 11 and the second housing 12 is provided with a first snap 16, and the other is provided with a second snap 17. The first snap 16 is elastically deformable and provided with a snap cavity 161. When the first housing 11 and the second housing 12 are snapped, the first snap 16 elastically deforms to allow the second snap 17 to snap into the snap cavity 161 of the first snap 16.

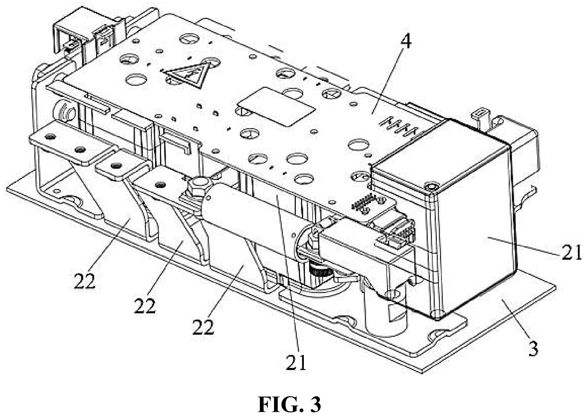

With reference to FIG. 2 and FIG. 3, the internal component 2 of the battery disconnect unit 110 includes an electronic component 21 and a busbar 22, where the busbar 22 is electrically connected to the electronic component 21, and the busbar 22 is connected to an external lead (such as the copper bar 30 in FIG. 1) of the battery disconnect unit 110. The busbar 22 is exemplarily a conductive copper bar or a conductive aluminum bar. The electronic component 21 of the battery disconnect unit 110 includes control switches (such as relays) for controlling the opening and closing of multiple circuits, overcurrent fuses, and the like. During operation of the battery disconnect unit 110, the busbar 22 generates a significant amount of heat.

In this embodiment, the busbar 22 is embedded in the second housing 12 of the housing assembly 1 and is in contact with the heat-conducting member 3, allowing the heat-conducting member 3 to conduct heat from the busbar 22 to the outside of the housing assembly 1.

With reference to FIG. 4, FIG. 5, FIG. 6, and FIG. 7, a limiting groove 121 is recessed on an outer wall of the second housing 12 of the housing assembly 1, and the busbar 22 is partially snapped into the limiting groove 121 and in contact with the heat-conducting member 3. The limiting groove 121 is provided. On the one hand, the limiting groove is configured to snap the busbar 22, ensuring the installation stability of the busbar 22 on the second housing 12. On the other hand, the portion of the busbar 22 snapped into the limiting groove 121 is exposed through the bottom of the housing assembly 1, enabling direct contact with the heat-conducting member 3 and increasing the heat dissipation and cooling rate of the busbar 22.

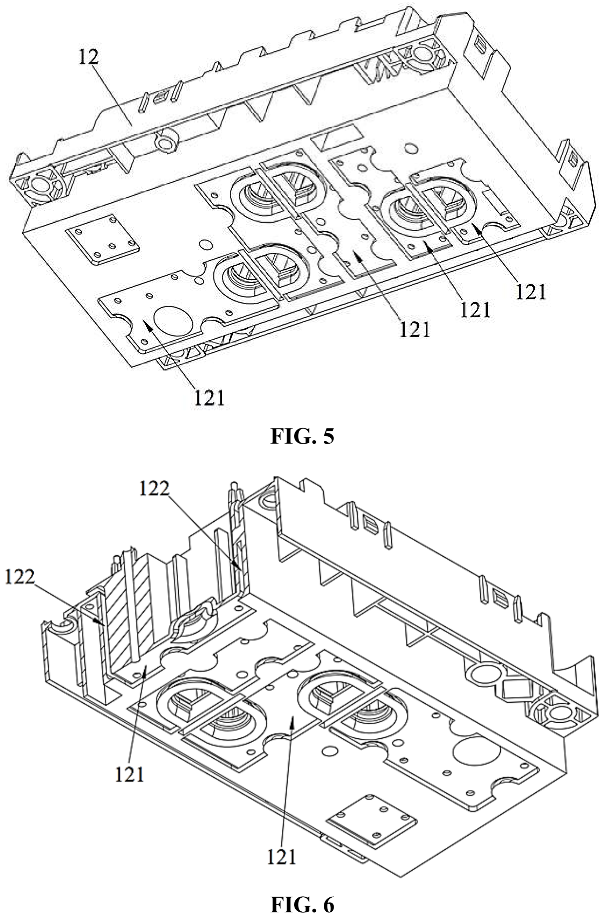

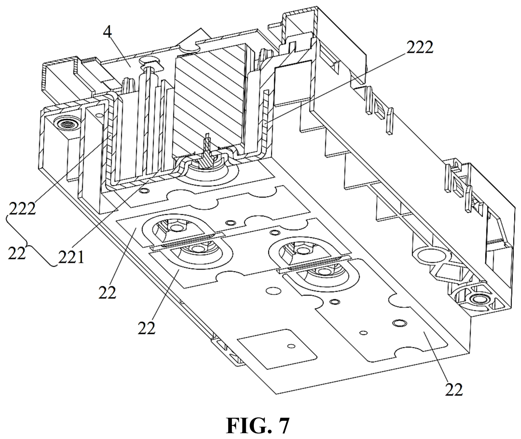

With reference to FIG. 7, the busbar 22 includes a heat dissipation portion 221 and an installation portion 222 connected at an angle. The heat dissipation portion 221 is embedded in the limiting groove 121 and configured to contact the heat-conducting member 3 for heat dissipation and cooling. The installation portion 222 is embedded inside the second housing 12. With reference to FIG. 6, an embedding channel 122 communicating with the limiting groove 121 is disposed on the second housing 12, and the installation portion 222 is embedded in the embedding channel 122, achieving stable installation of the busbar 22.

Exemplarily, with reference to FIG. 6 and FIG. 7, two ends of the heat dissipation portion 221 are provided with installation portions 222, and correspondingly, two ends of the limiting groove 121 of the second housing 12 are provided with embedding channels 122. The installation portions 222 at two ends of the heat dissipation portion 221 are embedded in the two embedding channels 122 in a one-to-one correspondence.

In some embodiments, with reference to FIG. 2 and FIG. 4, the heat-conducting member 3 of the battery disconnect unit 110 includes a first fitting portion 31 and a second fitting portion 32 connected to each other, the first fitting portion 31 and the second fitting portion 32 are arranged to form a groove configured to snap the housing assembly 1, and the housing assembly 1 fits against an inner wall of the groove. The heat-conducting member 3 forms the groove, which, on the one hand, enhances the fixation strength after the heat-conducting member 3 is installed with the housing assembly 1. The configuration, on the other hand, can increase the contact area between the heat-conducting member 3 and the housing assembly 1, allowing the heat-conducting member 3 to fully contact all busbars 22 at the bottom of the second housing 12 and improving effectiveness and uniformity of heat dissipation.

In other embodiments, with reference to FIG. 3, the heat-conducting member 3 of the battery disconnect unit 110 is sheet-shaped and fits against the internal component 2, or the heat-conducting member 3 fits against both the housing assembly 1 and the internal component 2. For example, the heat-conducting member 3 includes multiple heat-conducting sheets, and each heat-conducting sheet may correspond to a busbar 22 exposed through the limiting groove 121 of the second housing 12. The heat-conducting sheet is attached to the corresponding busbar 22 to achieve heat dissipation for the busbar 22. Alternatively, as shown in FIG. 3, the heat-conducting member 3 covers the entire surface of the second housing 12 and fits against both the outer surface of the second housing 12 and the busbar 22 snapped into the limiting groove 121. Alternatively, the heat-conducting member 3 includes multiple heat-conducting sheets. One part of the heat-conducting sheets fits against the busbar 22 snapped into the limiting groove 121, while another part contacts the outer surface of the second housing 12.

As shown in FIG. 8, FIG. 9, and FIG. 10, schematic diagrams of the structure of the boost unit 120 are provided. The housing assembly 1 of the boost unit 120 includes a third housing 13, a fourth housing 14, and a bottom cover 15. The third housing 13 and the bottom cover 15 are respectively snapped on opposite sides of the fourth housing 14 to form a chamber configured to accommodate the internal component 2. One of the third housing 13 and the fourth housing 14 is provided with a first snap 16, and the other is provided with a second snap 17. The first snap 16 is elastically deformable and provided with a snap cavity 161. When the third housing 13 and the fourth housing 14 are snapped, the first snap 16 elastically deforms to allow the second snap 17 to snap into the snap cavity 161 of the first snap 16. Similarly, one of the fourth housing 14 and the bottom cover 15 is provided with a first snap 16, and the other is provided with a second snap 17 that snaps into the first snap 16.

Exemplarily, multiple first snaps 16 are circumferentially arranged on the third housing 13 and the bottom cover 15, and multiple second snaps 17 are circumferentially spaced at the upper and lower ends of the fourth housing 14. The first snaps 16 snap into the corresponding second snaps 17, achieving the connection of the third housing 13, the fourth housing 14, and the bottom cover 15.

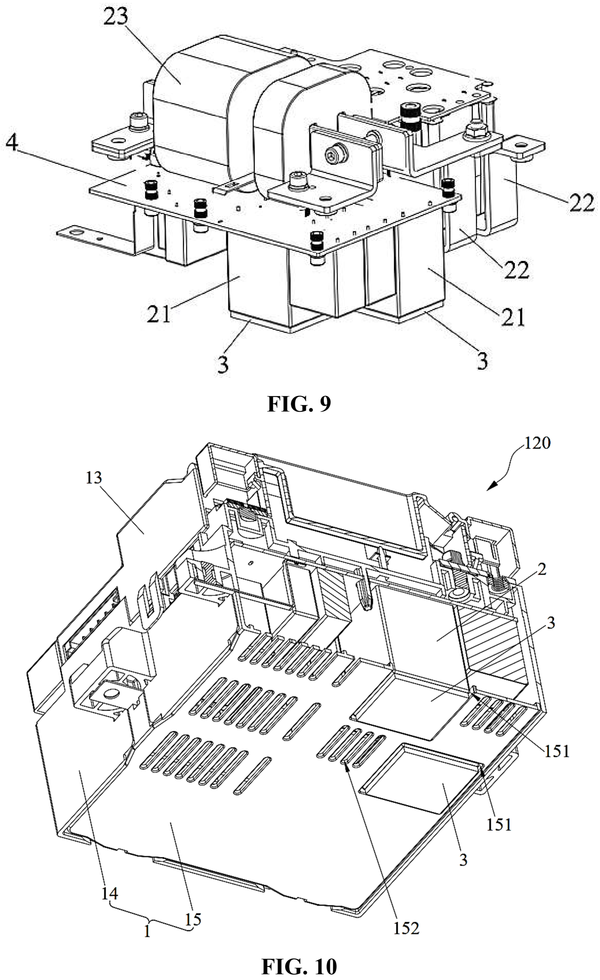

With reference to FIG. 8 and FIG. 9, the internal component 2 of the boost unit 120 also includes an electronic component 21 and a busbar 22, where the busbar 22 is electrically connected to the electronic component 21, and the busbar 22 is configured to connect to an external lead (such as the copper bar 30 in FIG. 1) of the boost unit 120. The busbar 22 is exemplarily a conductive copper bar or a conductive aluminum bar. The boost unit 120 is provided with a high-voltage input terminal and an output terminal. The electronic component 21 of the boost unit 120 includes boost components, relays for controlling on-off states, and other components.

The internal component 2 of the boost unit 120 also includes a filtering module 23 disposed on the boost circuit. The filtering module 23 can filter the boost circuit and reduce interference with the electronic component 21.

Exemplarily, the filtering module 23 is an electromagnetic ring filter.

When the boost unit 120 boosts the voltage of a standard charging pile to 800 V for charging, electromagnetic interference occurs during the boosting process. By the filter of the boost circuit with an electromagnetic ring filter, interference with devices such as the battery management system (BMS) 20 is reduced, making the fast-charging process safer and more stable.

With reference to FIG. 8 and FIG. 10, an accommodation hole 151 penetrates through an outer wall of the housing assembly 1 and is configured to enable the contact between the heat-conducting member 3 and the internal component 2, thereby dissipating heat for the internal component 2 of the boost unit 120.

In some embodiments, at least one internal component 2 is partially located within the accommodation hole 151 and in contact with the heat-conducting member 3. With reference to FIG. 10, one end of the internal component 2 extends into the accommodation hole 151 and fits against the heat-conducting member 3, and the heat-conducting member 3 is exposed through the accommodation hole 151, conducting heat to the outside of the housing assembly 1. It can be understood that the heat-conducting member 3 may be partially located within the accommodation hole 151, that is, one end of the internal component 2 and a portion of the heat-conducting member 3 are both located within the accommodation hole 151 and fit against each other. Alternatively, the internal component 2 penetrates through the accommodation hole 151 to fit against the heat-conducting member 3 outside the accommodation hole 151.

In other embodiments, the internal component 2 may be entirely located within the housing assembly 1 of the boost unit 120 without extending into the accommodation hole 151. In this case, a portion of the heat-conducting member 3 is exposed through the housing assembly 1, while another portion penetrates through the accommodation hole 151 and contacts the internal component 2, conducting heat from the internal component 2 to the outside.

It can be understood that for the boost unit 120, the heat dissipation method of the internal component 2 used in the battery disconnect unit 110 may also be adopted, that is, providing a limiting groove 121 on the housing assembly 1. Similarly, for the battery disconnect unit 110, the heat dissipation method of the internal component 2 used in the boost unit 120 may also be adopted, that is, providing an accommodation hole 151 on the housing assembly 1.

With reference to FIG. 8 and FIG. 10, a heat dissipation hole 152 is disposed on the bottom cover 15 of the housing assembly 1 of the boost unit 120 and is configured to rapidly dissipate heat from within the housing assembly 1, thereby improving effectiveness of heat dissipation. Optionally, the heat dissipation hole 152 is disposed on the bottom cover 15 at a position directly facing the internal component 2, enhancing the efficiency of heat dissipation of the internal component 2.

For the battery disconnect unit 110, a heat dissipation hole 152 may also be disposed on the housing assembly 1.

With reference to FIG. 2 and FIG. 8, installation grooves 18 configured to accommodate the internal components 2 are disposed on the second housing 12 of the battery disconnect unit 110 and the fourth housing 14 of the boost unit 120.

Exemplarily, the heat-conducting member 3 may include, but is not limited to, a thermal conductive silicone pad, thermal conductive potting adhesive, or heat dissipation fins.

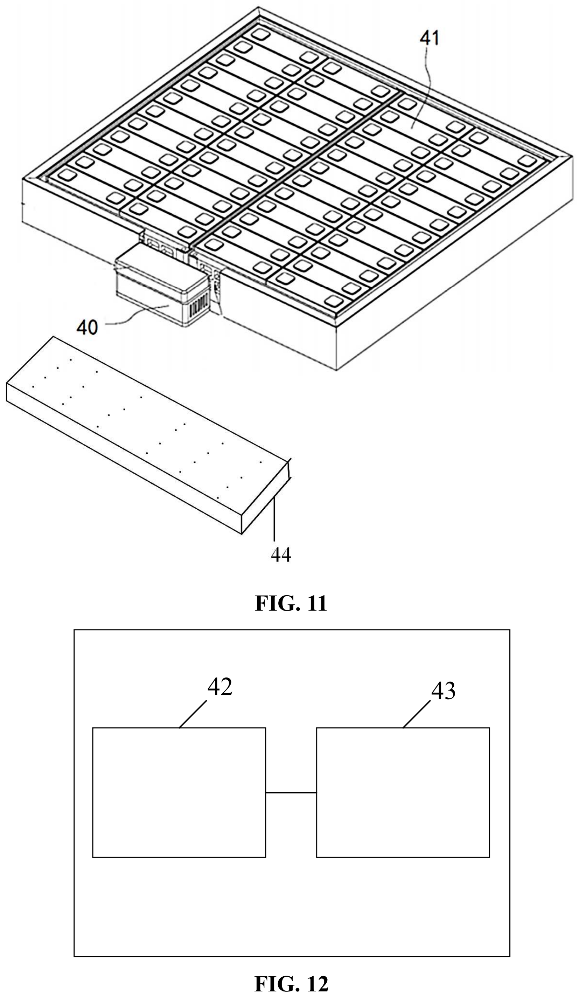

As shown in FIG. 11, this embodiment also provides a battery pack including a casing, a battery module 41, and a power distribution system 40. The battery module 41 and the power distribution system 40 are both installed inside the casing, and the battery module 41 is electrically connected to the power distribution system 40, enabling charging and discharging of the battery through the power distribution system 40.

As shown in FIG. 11, the battery pack also includes a cooling plate 44 configured to cool the battery module 41, and the cooling plate 44 is installed inside the casing.

In some embodiments, the power distribution unit 10 is placed on the cooling plate, and the heat-conducting member 3 is in direct or indirect contact with the cooling plate. Heat generated by the internal component 2 of the power distribution unit 10 is conducted through the heat-conducting member 3 and dissipated through direct or indirect contact with the cooling plate.

Specifically, in this embodiment, both the battery disconnect unit 110 and the boost unit 120 are placed on the cooling plate of the battery pack, and the heat-conducting member 3 at the bottom is in direct contact with the cooling plate or achieves indirect contact by being bonded to the cooling plate through a thermal conductive structural adhesive. The cooling plate can remove heat from the heat-conducting member 3, thereby achieving heat dissipation for the internal component 2 of the battery disconnect unit 110 and the boost unit 120.

With reference to FIG. 2 and FIG. 3, a circuit board 4 is installed within the housing assembly 1 of the battery disconnect unit 110, and the internal component 2 of the battery disconnect unit 110 is electrically connected to the circuit board 4. With reference to FIG. 8 and FIG. 9, a circuit board 4 is also disposed within the housing assembly 1 of the boost unit 120, and the internal component 2 of the boost unit 120 is electrically connected to the circuit board 4.

For the battery disconnect unit 110 and the boost unit 120, at least one internal component 2 is located on a side of the circuit board 4 facing the heat-conducting member 3. When the battery disconnect unit 110 and the boost unit 120 are placed on the cooling plate, the internal component 2 located on the side of the circuit board 4 facing the heat-conducting member 3 is closer to the cooling plate, shortening the heat conduction path and meeting the bottom heat dissipation requirements of the battery disconnect unit 110 and the boost unit 120. For example, part or all of the electronic components 21 and busbars 22 are located on the side of the circuit board 4 facing the heat-conducting member 3, that is, part or all of the electronic components 21 and busbars 22 are arranged upside down and are closer to the cooling plate, achieving better heat dissipation.

In the embodiment, the heat-conducting member 3 of the battery disconnect unit 110 and the boost unit 120 dissipates heat through the cooling plate of the battery pack, saving space while ensuring effectiveness of heat dissipation.

In other embodiments, with reference to FIG. 2 and FIG. 4, a separate heat dissipation module 5 may be provided for the power distribution unit 10, and the heat dissipation module 5 is located outside the housing assembly 1 and in contact with the heat-conducting member 3. Heat generated by the internal component 2 is conducted to the heat-conducting member 3, and the heat dissipation module 5 removes heat from the heat-conducting member 3.

Exemplarily, the heat dissipation module 5 may be a cold plate module, such as a liquid cooling plate module, which achieves heat dissipation and cooling through flowing coolant inside. The heat dissipation module 5 may or may not be in contact with the cooling plate of the battery pack, and the flow channels for circulating coolant inside the heat dissipation module 5 may or may not be connected to the internal flow channels of the cooling plate.

As shown in FIG. 12, this embodiment also provides an electrical device including an electrical component 43 and a battery pack 42. The battery pack 42 is configured to provide electrical energy to the electrical component 43. The electrical device provided can ensure continuous and reliable power supply to the electrical component while reducing heat generation during power supply. Due to the high-capacity battery pack, the duration of power supply to the electrical component can be extended, enabling the electrical device to have a long battery life and improved practicality.

The electrical device may include, but is not limited to, electric tools, electric scooters, electric vehicles, ships, and spacecraft. For example, the electrical device is a vehicle. The battery pack may serve as the power system of the vehicle and provide electrical energy to the electrical component to achieve corresponding functions.

The battery pack described in the embodiments of this application is not limited to the electrical devices described herein but can be applied to all other electrical devices using batteries. For brevity, the following description takes a vehicle as an example of an electrical device.

The vehicle may be a fuel vehicle, a gas vehicle, or a new energy vehicle. The new energy vehicle may be a pure electric vehicle, a hybrid vehicle, or an extended-range vehicle. A battery pack is disposed inside the vehicle, and the battery pack may be disposed at the bottom, front, or rear of the vehicle. The battery pack may be configured to supply power to the vehicle. For example, the battery pack may serve as the operating power source of the vehicle. The vehicle may also include a controller and a motor. The controller is configured to control the battery pack to supply power to the motor, for example, for the starting, navigation, and driving power requirements of the vehicle. In the vehicle provided by this embodiment, the battery pack can continuously and reliably supply power to the electrical component, enhancing the power supply duration for the electrical component and providing the vehicle with high endurance, improved practicality, and a better user experience.

Other types of electrical devices are not individually described here.

## Claims

1. A power distribution system, comprising at least one power distribution unit (10), wherein a power distribution unit (10) of the at least one power distribution unit (10) comprises:
a housing assembly (1);
at least one internal component (2) disposed within the housing assembly (1); and
a heat-conducting member (3) at least partially exposed outside the housing assembly (1), wherein a portion of the heat-conducting member (3) facing inside the housing assembly (1) is in contact with at least one internal component (2).

2. The power distribution system according to claim 1, wherein an accommodation hole (151) penetrates through an outer wall of the housing assembly (1); and
at least one internal component (2) is partially located within the accommodation hole (151), and the heat-conducting member (3) is at least partially located within the accommodation hole (151) to fit against the at least one internal component (2) within accommodation hole (151); or, the heat-conducting member (3) penetrates through the accommodation hole (151) and is in contact with the at least one internal component (2).

3. The power distribution system according to claim 1, wherein an internal component (2) of the at least one internal component (2) comprises an electronic component (21) and a busbar (22), and the busbar (22) is electrically connected to the electronic component (21); and
a limiting groove (121) is recessed on an outer wall of the housing assembly (1), and the busbar (22) is partially snapped into the limiting groove (121) and in contact with the heat-conducting member (3).

4. The power distribution system according to claim 1, wherein
the heat-conducting member (3) comprises a first fitting portion (31) and a second fitting portion (32) connected to each other, the first fitting portion (31) and the second fitting portion (32) are arranged to form a groove configured to snap the housing assembly (1), and the housing assembly (1) fits against an inner wall of the groove; or
the heat-conducting member (3) is sheet-shaped, and the heat-conducting member (3) fits against the at least one internal component (2) or fits against both the housing assembly (1) and the at least one internal component (2).

5. The power distribution system according to claim 1, wherein the housing assembly (1) is provided with a heat dissipation hole (152).

6. The power distribution system according to claim 1, wherein the power distribution unit (10) further comprises:
a circuit board (4) installed within the housing assembly (1) and electrically connected to the at least one internal component (2), wherein at least one internal component (2) is located on a side of the circuit board (4) facing the heat-conducting member (3).

7. The power distribution system according to claim 1, wherein the power distribution unit (10) further comprises a heat dissipation module (5), and the heat dissipation module (5) is located outside the housing assembly (1) and in contact with the heat-conducting member (3).

8. The power distribution system according to any one of claims 1 to 7, further comprising a fast-charging interface (45) and a boost circuit (46), wherein the fast-charging interface (45) is electrically connected to the boost circuit (46), a plurality of power distribution units (10) are provided, two of the plurality of power distribution units (10) are a battery disconnect unit (110) and a boost unit (120), respectively, and both the battery disconnect unit (110) and the boost unit (120) are disposed on the boost circuit (46).

9. The power distribution system according to claim 8, wherein an internal component (2) of the boost unit (120) comprises a filtering module (23) disposed on the boost circuit.

10. A battery pack, comprising a battery module (41) and the power distribution system (40) according to any one of claims 1 to 9, wherein the battery module (41) is electrically connected to the power distribution system (40).

11. The battery pack according to claim 10, further comprising a cooling plate (44) configured to cool the battery module (41), wherein the power distribution unit (10) is placed on the cooling plate (44), and the heat-conducting member (3) is in direct or indirect contact with the cooling plate (44).

12. An electrical device, comprising an electrical component (43) and the battery pack (42) according to claim 10 or 11, wherein the battery pack (42) is configured to provide electrical energy to the electrical component (43).
